# EUROPEAN PATENT SPECIFICATION

(11) **EP 4 607 583 B1**
(45) Date of publication and mention of the grant of the patent: **10.06.2026**
(21) Application number: 24193092.4
(22) Date of filing: 06.08.2024
(51) Int. Cl.: H10W 74/10, H10W 70/60, H10W 70/63, H10W 40/22, H10W 40/25, H10W 70/65

(54) **POWER CHIP EMBEDDED PACKAGE SUBSTRATE AND PACKAGING METHOD**
IN EINEN LEISTUNGSCHIP EINGEBETTETES VERKAPSELUNGSSUBSTRAT UND VERKAPSELUNGSVERFAHREN
SUBSTRAT DE BOÎTIER INTÉGRÉ À UNE PUCE DE PUISSANCE ET PROCÉDÉ D'ENCAPSULATION

(30) Priority: 20.02.2024 CN 202410188215
(43) Date of publication of application: 27.08.2025
(73) Proprietor: Shennan Circuits Co., Ltd., Shenzhen City, Guangdong 518100 (CN)
(72) Inventor: WANG, Zedong, Shenzhen City, Guangdong Province, 518100 (CN); HUANG, Lixiang, Shenzhen City, Guangdong (CN)
(74) Representative: Herrero & Asociados, S.L.

(56) References cited:
- WO-A1-2015/135249
- US-A1- 2015 380 356
- US-A1- 2017 162 556
- US-A1- 2018 019 178
- US-A1- 2018 240 729
- US-A1- 2023 282 591

## Description

### Technical field

The present application belongs to the technical field of package substrate manufacturing, in particular to a power chip embedded package substrate and a packaging method.

### Background

The third generation semiconductor materials, SiC (silicon carbide) and GaN (gallium nitride), have the advantages of wide band gap, high breakdown electric field, high thermal conductivity, high electron saturation rate, and strong radiation resistance. Semiconductor power devices made of third-generation semiconductor materials can not only run stable at higher temperatures, but they are also suitable for high-voltage and high-frequency environments, and they can achieve better operation with less power consumption.

Various packaging techniques have been developed to address the demands for high current capacity, thermal efficiency, and miniaturization in power semiconductor modules.

US 2018/019178 A1 discloses a stepped copper substrate on which a chip is mounted and encapsulated. Circuit connections are formed over the encapsulant. While it offers good thermal and current handling, it lacks vertical interconnections and direct signal fan-out.

US 2015/0380356 A1 describes embedding a chip in curable dielectric layers with vias for electrical interconnection. Although it supports vertical connections, it does not integrate the chip with a rigid substrate or provide blind-hole fan-out for signal optimization.

US 2023/282591 A1 shows a die carrier with a chip, encapsulant, and insulation layer. Some vias provide both electrical and thermal paths. However, it does not embed the chip in the substrate or allow for direct signal fan-out through blind holes.

Nevertheless, the benefits of third-generation semiconductor materials cannot be fully realized with the substrate packaging techniques currently in use. Take the traditional TO247 packaging as an example, the back of bare chip is fixed on cushion block, and the other side transmits signals by wire bonding, and the whole bare chip is plastic-sealed. The bare chip needs to be connected with the substrate through pins, which results in long signal transmission path, large electrical performance loss and large space occupied by the package.

### Summary of the invention

In the current packaging substrate, the chip is packaged outside the substrate and connected to it in a plug-in manner, resulting in a long signal transmission path, significant electrical performance loss, and a large space occupied by the packaging body. To address this problem, the present application provides a power chip embedded package substrate and a packaging method.

To solve the above technical problems, in one aspect, the embodiments of the present application provide a packaging method for a power chip embedded package substrate, which includes the following steps:
acquiring a first chip board, and opening a through groove penetrating along a thickness direction on the first chip board;
fixing a bare chip on a rigid substrate;
embedding the bare chip and the rigid substrate as a whole into the through groove of the first chip board;
pressing an insulation layer on the first chip board, the insulation layer covers the bare chip in the through groove;
forming a first external connection metal layer on the insulation layer; and
machining a plurality of blind holes on a surface of the first external connection metal layer, the blind holes realize 3D vertical interconnection between the bare chip and the first external connection metal layer, and between the rigid substrate and the first external connection metal layer, respectively;
before embedding the bare chip and the rigid substrate as a whole into the through groove of the first chip board, the method further includes:
   fixing a cushion block on the rigid substrate, the cushion block and the bare chip are positioned at the same side of the rigid substrate; and
   performing signal fan-out of the bare chip, by the cushion block via the blind hole;
   forming a thermal barrier on the first external connection metal layer;
   acquiring a second chip board, forming a second internal connection metal layer on a side surface of the second chip board, and forming a second external connection metal layer on another side surface of the second chip board;
   pressing the second internal connection metal layer of the second chip board on the thermal barrier to obtain a multilayer board; and
   performing drilling, copper deposition and electroplating process on the multilayer board.

Optionally, pressing an insulation layer on the first chip board, the insulation layer covers the bare chip in the through groove includes:
forming the insulation layer on a side surface of the first chip board facing away from the rigid substrate, and the insulation layer fills the through groove and wraps the bare chip.

Optionally, a side surface of the rigid substrate facing away from the bare chip is flush with a surface of the first chip board.

Optionally, the method further includes:
forming a heat conducting layer on a side surface of the first chip board facing away from the first external connection metal layer;
forming a first internal connection metal layer on the heat conducting layer;
machining a heat conducting hole extending along the thickness direction of the first chip board on a surface of the first internal connection metal layer, and exposing the rigid substrate from the heat conducting hole; and
forming a heat conducting pillar in the heat conducting hole.

Optionally, the step of machining a plurality of blind holes on a surface of the first external connection metal layer, the blind holes realize 3D vertical interconnection between the bare chip and the first external connection metal layer, and between the rigid substrate and the first external connection metal layer includes:
windowing the first external connection metal layer to form a plurality of open pores, and exposing the insulation layer from the open pores; and
machining a conductive hole extending along the thickness direction of the first chip board at an exposure position of the insulation layer to form the blind hole.

Optionally, the conductive hole is processed by laser drilling and hole metallization.

Optionally, the step of fixing a bare chip on a rigid substrate includes:
fixing the bare chip on the rigid substrate through nano-silver sintering, eutectic bonding or reflow soldering process.

In the packaging method for a power chip embedded package substrate of the present application, the bare chip and rigid substrate are integrated and embeded into the through groove of the first chip board. The insulation layer and rigid substrate cover the two sides of the bare chip, so that bare chip is insulated and encapsulated in the first chip board. The blind hole realizes 3D vertical interconnection of the bare chip and rigid substrate with the first external connection metal layer, allowing the bare chip to fan out signals directly through the blind hole, thus reducing the signal transmission path and transmission loss. Furthermore, because the bare chip is embedded in the first chip board, space can be freed up for the surface of the package substrate, allowing more electronic components to be mounted on the surface of the package substrate, thus reducing the overall space occupied by the package substrate, and facilitating module integration and miniaturization.

### Brief description of drawings

Figs. 1a to 1e are process flow charts of the packaging method for a power chip embedded package substrate provided by an embodiment of the present application.
Figs. 2 to 4 are structural schematic diagrams of a power chip embedded package substrate provided by another embodiment of the present application.

Reference signs in the drawings are as follows.
1. Bare chip; 2. Rigid substrate; 3. First chip board; 4. Insulation layer; 5. First external connection metal layer; 6. Conductive pillar; 7. Connecting pillar; 8. First internal connection metal layer; 9. Cushion block; 10. Thermal barrier; 11. Second chip board; 12. Second internal connection metal layer; 13. Second external connection metal layer; 14. Heat conducting pillar; 15. Heat conducting layer; 16. Blind hole.

### Detailed description of preferred embodiments

In order to make the technical problems, technical solutions and beneficial effects of the present application more clear, the application will be further explained in detail below with reference to the drawings and embodiments. It should be understood that the specific embodiments described here are only used to illustrate the application, rather than to limit the application.

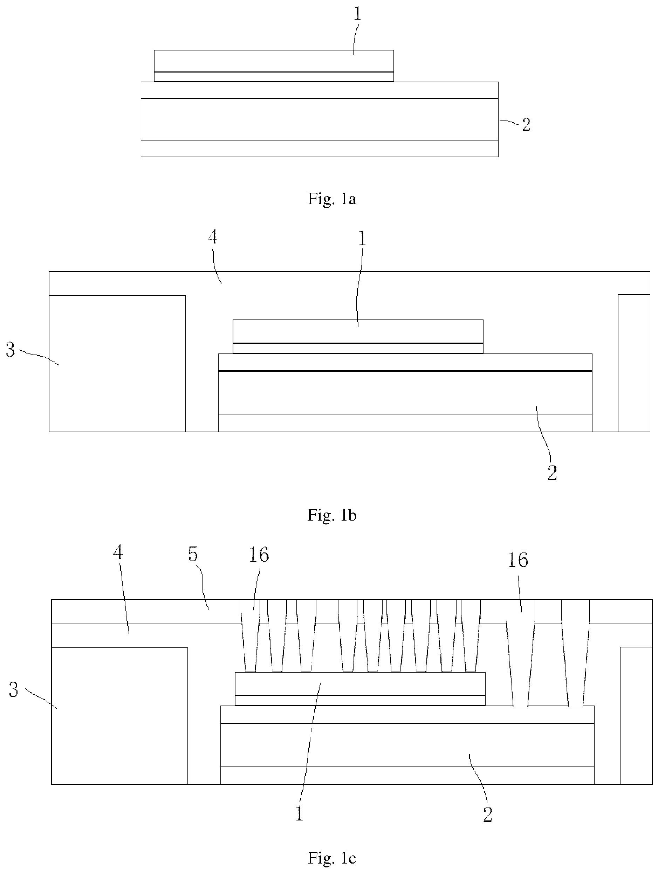

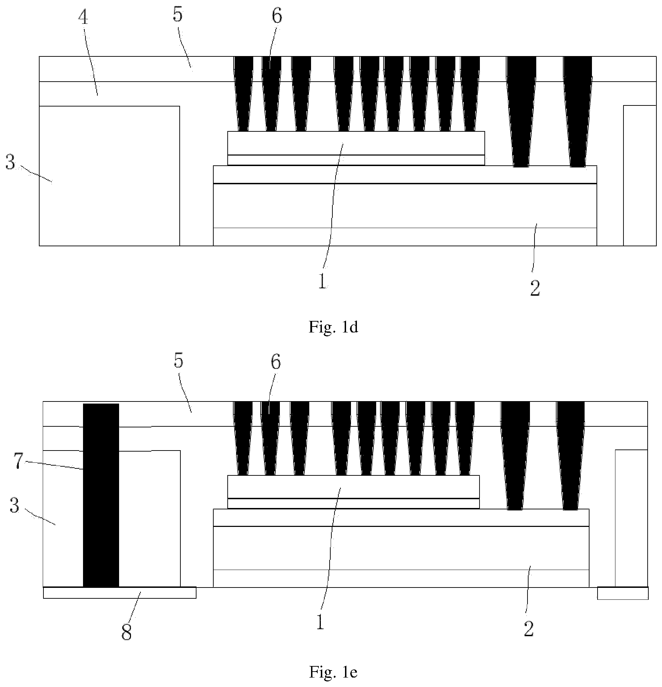

As shown in Figs. 1a to 1e, an embodiment of the present application provides a packaging method for a power chip embedded package substrate, which includes the following steps:
S1: acquiring a first chip board 3, and opening a through groove penetrating along a thickness direction on the first chip board 3;
S2: fixing a bare chip 1 on a rigid substrate 2;
S3: embedding the bare chip 1 and the rigid substrate 2 as a whole into the through groove of the first chip board 3;
S4: pressing an insulation layer 4 on the first chip board 3, the insulation layer 4 covers the bare chip 1 in the through groove;
S5: forming a first external connection metal layer 5 on the insulation layer 4; and
S6: machining a plurality of blind holes 16 on a surface of the first external connection metal layer 5, the blind holes 16 realize 3D vertical interconnection between the bare chip 1 and the first external connection metal layer 5, and between the rigid substrate 2 and the first external connection metal layer 5, respectively.

The rigid substrate 2 is made of high thermal conductivity material. In step S4, both sides of the bare chip 1 embedded in the through groove are covered by the insulation layer 4 and rigid substrate 2 respectively. The periphery of bare chip 1 is surrounded by first chip board 3. In this way, the bare chip 1 is insulated and packaged in the through groove of the first chip board 3, allowing the package substrate to come into direct contact with the cooler or other heat dissipation devices, which is beneficial to the heat dissipation of the package substrate, without coating insulating thermal conductive silicone grease between the first chip board 3 and the cooler.

Compared with thermal conductive silicone grease, the rigid substrate 2 has higher thermal conductivity, which is beneficial to directionally transfer the heat generated by the bare chip 1 to the bottom of the first chip board 3 and improve the heat dissipation efficiency of the bare chip 1.

Furthermore, the blind hole 16 can also transfer the heat generated by the bare chip 1 to the top of the first chip board 3, further improving the heat dissipation efficiency of the bare chip 1.

The blind hole process is a conventional process in the field of package substrate manufacturing. The blind hole is made by punching holes on the surface of the first external connection metal layer 5, then depositing copper on the hole wall to obtain a conductive layer and electroplating in the hole to obtain a conductive pillar 6.

Some of the blind holes 16 are arranged corresponding to the bare chip 1, and the conductive pillar 6 in the corresponding blind hole 16 is electrically connected with the circuit at the top of the bare chip 1 and the first external connection metal layer 5. Some of the blind holes 16 are arranged corresponding to the rigid substrate 2, and the conductive pillar 6 in the corresponding blind hole 16 is electrically connected with the lead wire at the bottom of the bare chip 1 and the first external connection metal layer 5. This allows for the 3D vertical interconnection of bare chip 1 and rigid substrate 2 with the first external connection metal layer 5, effectively fanning out the signals of the bare chip 1.

It should be noted that the blind hole 16 may be replaced by a blind groove, and the shapes of the blind hole 16 and the blind groove are different. The blind hole 16 is usually round, and the blind groove is usually square or other shapes.

According to the packaging method for a power chip embedded package substrate of the present application, the bare chip 1 and rigid substrate 2 are integrated and embedded in the through groove of first chip board 3. The insulation layer 4 and rigid substrate 2 cover the two sides of the bare chip 1, allowing the bare chip 1 to be insulated and encapsulated in first chip board 3. The blind hole 16 realizes 3D vertical interconnection of the bare chip 1 and rigid substrate with the first external connection metal layer 5, allowing the bare chip 1 to fan out signals directly through the blind hole 16, thus reducing the signal transmission path and transmission loss. Furthermore, because the bare chip 1 is embedded in the first chip board 3, space can be freed up for the surface of the package substrate, allowing more electronic components to be mounted on the surface of the package substrate, thus reducing the overall space occupied by the package substrate, and facilitating module integration and miniaturization.

In an embodiment, in step S2, the bare chip 1 is fixed on the rigid substrate 2 by the process of nano-silver sintering, eutectic bonding or reflow soldering. A sintered layer or solder layer is shown in the figures, which are collectively referred to as a connection layer.

In an embodiment, the rigid substrate 2 is a metal block (copper block, molybdenum copper block), DBC, or AMB substrate. Here, DBC and AMB substrates are made of thick copper on both sides of high thermal conductivity insulating ceramic sheets.

In an embodiment, in step S4, the insulation layer 4 is formed on the surface of the first chip board 3 facing away from the rigid substrate 2 and fills the through groove, and the insulation layer 4 wraps the bare chip 1. The bare chip 1 is packaged by the insulation layer 4 and the rigid substrate 2, and the bare chip 1 does not need to be packaged with the assistance of the first chip board 3, so that the air gap between the bare chip 1 and the first chip board 3 can be avoided from affecting the packaging heat dissipation effect of the bare chip 1.

In an embodiment, in step S4, the surface of the rigid substrate 2 facing away from the bare chip 1 is flush with the surface of the first chip board 3, so that the surface of the package is flat, and it is convenient for mounting cooler, copper foil layer or other components. Moreover, the rigid substrate 2 can directly contact the cooler or other heat dissipation devices to dissipate heat, so as to avoid filling the back of the rigid substrate 2 with extra insulating resin material and affecting the heat dissipation effect.

In an embodiment, step S6 includes:
S61: windowing the first external connection metal layer 5 to form a plurality of open pores, and exposing the insulation layer 4 from the open pores; and
S62: machining a conductive hole extending along the thickness direction of the first chip board 3 at an exposure position of the insulation layer 4 to form the blind hole 16.

In an embodiment, the conductive hole is processed by laser drilling and hole metallization.

It should be noted that the conductive hole may be replaced by conductive groove. The conductive groove and conductive hole have different shapes but the same function. The conductive groove is processed by laser burning and groove metallization.

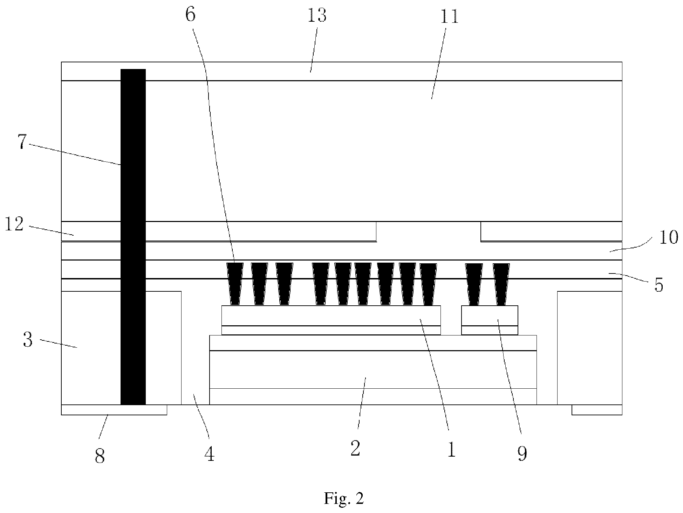

In other embodiments, as shown in Fig. 2, before step S3, the cushion block 9 may be fixed on the rigid substrate 2.

Here, the cushion block 9 and bare chip 1 are fixed on the same side of the rigid substrate 2, some of the blind holes 16 are machined facing towards the cushion block 9, and the lead wire at the bottom of bare chip 1 is electrically connected with the blind hole 16 through the cushion block 9. As a result, the corresponding blind hole 16 only needs to be processed until the cushion block 9 is exposed, reducing the depth of the corresponding the blind hole 16 as well as its processing difficulty.

The cushion block 9 may be a copper block or a molybdenum copper block. The copper block or molybdenum copper block is fixed on the rigid substrate 2 by the process of nano-silver sintering, eutectic bonding or reflow soldering.

In other embodiments, as shown in Fig. 2, the packaging method for a power chip embedded package substrate may further includes:
S7: forming a thermal barrier 10 on the first external connection metal layer 5;
S8: acquiring a second chip board 11, forming a second internal connection metal layer 12 on a side surface of the second chip board 11, and forming a second external connection metal layer 13 on another side surface of the second chip board 11;
S9: pressing the second internal connection metal layer 12 of the second chip board 11 on the thermal barrier 10 to obtain a multilayer board; and
S10: performing drilling, copper deposition and electroplating process on the multilayer board, so that the first external connection metal layer 5 and the second internal connection metal layer 12 are interconnected with the second external connection metal layer 13.

The step of "performing drilling, copper deposition and electroplating process on the multilayer board" refers to: processing a through hole penetrating along the thickness direction of the multilayer board, depositing copper on the hole wall to obtain a conductive layer, and electroplating in the hole to obtain a connecting pillar 7. Thus, the interconnection among the first external connection metal layer 5, the second internal connection metal layer 12 and the second external connection metal layer 13 is realized, allowing signals of the bare chip 1 embedded in the first chip board 3 to be fanned out. Drilling, copper deposition and electroplating are conventional processes in the technical field of manufacturing the package substrate, which will not be described in detail.

Because electronic components will be attached to the surface of the second external connection metal layer 13 of the second chip board 11, the running temperature of bare chip 1 based on the third generation semiconductor material would reach 200°C or even higher, and the normal operation of other devices would be affected after the heat is transferred to the second external connection metal layer 13. Therefore, the arrangement of the thermal barrier 10 between the first chip board 3 and the second chip board 11 can help prevent heat from being transferred to the surface of the second chip board 11, and control the directional heat dissipation of the package substrate, so as to avoid affecting the normal operation of other electronic components.

It should be noted that one or a plurality of second chip boards 11 can be provided. When a plurality of second chip boards 11 are provided, a plurality of second chip boards 11 are stacked together and pressed on the first external connection metal layer 5 of the first chip board 3.

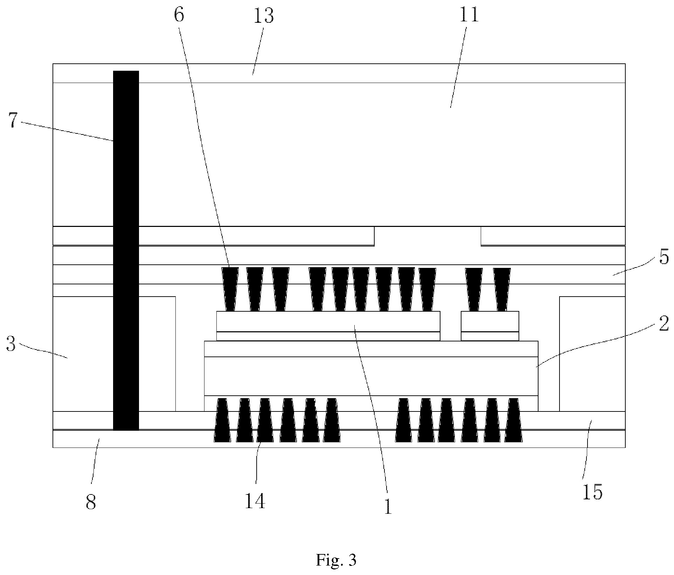

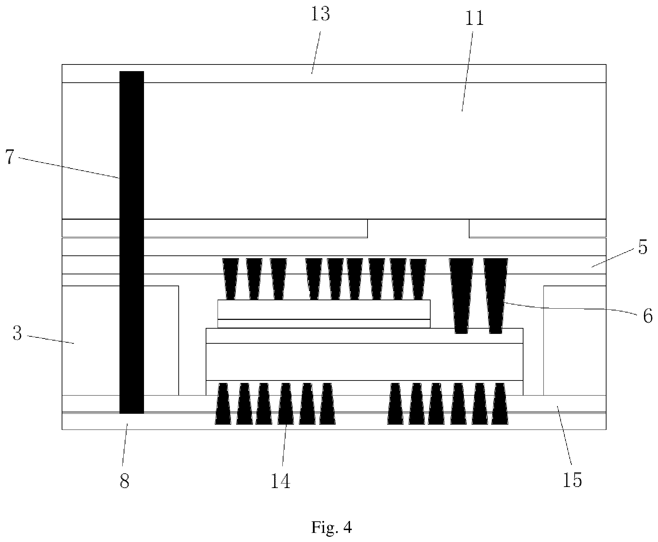

In other embodiments, as shown in Figs. 3 and 4, the packaging method for a power chip embedded package substrate may further include:
S11: forming a heat conducting layer 15 on a side surface of the first chip board 3 facing away from the first external connection metal layer 5;
S12: forming a first internal connection metal layer 8 on the heat conducting layer 15;
S13: machining a heat conducting hole extending along the thickness direction of the first chip board 3 on a surface of the first internal connection metal layer 8, and exposing the rigid substrate 2 from the heat conducting hole; and
S14: forming a heat conducting pillar 14 in the heat conducting hole.

At this point, both sides of the package substrate are covered with metal layers. In order to prevent the first internal connection metal layer 8 from reducing the heat dissipation efficiency of the bare chip 1, a heat conducting layer 15 is formed at the bottom of the first chip board 3. The heat conducting pillar 14 is machined in the heat conducting layer 15, allowing the bare chip 1 to radiate heat directionally to the bottom of the package substrate, thus improving the heat dissipation efficiency.

Here, the processing steps of heat conducting hole are: firstly, windowing the first internal connection metal layer 8 to form a plurality of open pores, and then processing holes extending to the rigid substrate 2 along the thickness direction of the first chip board 3 at the opening positions. The process of windowing is the prior art and will not be described in detail here.

In one embodiment, the heat conducting pillar 14 is formed by electroplating copper in the heat conducting hole.

In other embodiments, the rigid substrate 2 made of high thermal conductivity material can be provided with an accommodating groove, and in step S2, the bare chip 1 is fixed in the accommodating groove of the rigid substrate 2. In step S4, simply covering the bare chip 1 with the insulation layer 4 allows the bare chip 1to be insulated and packaged in the first chip board 3.

In addition, an embodiment of the present application provides a package substrate, as shown in Fig. 1e, the package substrate includes a first chip board 3, a first external connection metal layer 5, a bare chip 1, a rigid substrate 2 and an insulation layer 4; the first chip board 3 is provided with a through groove penetrating along the thickness direction, the bare chip 1 is fixed on the rigid substrate 2, and the bare chip 1 and rigid substrate 2 are embedded in the through groove.

The insulation layer 4 is arranged on the first chip board 3 and covers the side surface of the bare chip 1 facing away from the rigid substrate 2, and the first external connection metal layer 5 is arranged on the insulation layer 4.

A plurality of blind holes 16 including a first blind hole and a second blind hole are arranged on the package substrate, the first blind hole extends from the surface of the first external connection metal layer 5 to expose the bare chip 1, and the second blind hole extends from the surface of the first external connection metal layer 5 to expose the rigid substrate 2.

A conductive pillar 6 is formed in both the first blind hole and the second blind hole, the conductive pillar 6 in the first blind hole is electrically connected with the top circuit of the bare chip 1 and the first external connection metal layer 5 in contact, and the conductive pillar 6 in the second blind hole is electrically connected with the lead wire at the bottom of the bare chip 1 and the first external connection metal layer 5. In this way, the 3D vertical interconnection between the bare chip 1 and the first external connection metal layer 5 is realized.

It should be noted that the blind hole may be replaced by a blind slot. The blind hole and blind slot are different in shape, blind hole is usually round, and blind slot is usually square or other shapes.

In an embodiment, the insulation layer 4 is attached to the side surface of the first chip board 3 facing away from the rigid substrate 2 and fills the through groove, and the insulation layer 4 wraps the bare chip 1.

In an embodiment, the side surface of the rigid substrate 2 facing away from the bare chip 1 is flush with the surface of the first chip board 3, so that the back surface of the package substrate is flat and convenient for mounting electronic components.

In an embodiment, the bare chip 1 is fixed on rigid substrate 2 by the process of nano-silver sintering, eutectic bonding or reflow soldering.

In other embodiments, as shown in Fig. 2, it also includes a cushion block 9, which is fixed on rigid substrate 2. The cushion block 9 and bare chip 1 are located on the same side of the rigid substrate 2. The second blind hole is arranged corresponding to the cushion block 9, and the second blind hole 16 extends from the surface of the first external connection metal layer 5 to expose the cushion block 9, so as to reduce the depth of the second blind hole 16 and reduce the processing difficulty of the second blind hole 16.

The cushion block 9 may be a copper block or a molybdenum-copper block, and the copper block or the molybdenum-copper block is fixed on rigid substrate 2 by the process of nano-silver sintering, eutectic bonding or reflow soldering.

In other embodiments, as shown in Fig. 2, the package substrate further includes a second chip board 11, a thermal barrier 10 and a connecting pillar 7. One side surface of the second chip board 11 is provided with a second internal connection metal layer 12, and another side surface of the second chip board 11 is provided with a second external connection metal layer 13. The first chip board 3 and the second chip board 11 are stacked, and the thermal barrier 10 is arranged between the second internal connection metal layer 12 and the first external connection metal layer 5.

A connecting hole penetrating along the thickness direction of the first chip board 3 is arranged on the package substrate, and the connecting pillar 7 is arranged in the connecting hole. The connecting pillar 7 connects first external connection metal layer 5, second internal connection metal layer 12 and second external connection metal layer 13, thus realizing the vertical interconnection among the first external connection metal layer 5, second internal connection metal layer 12 and second external connection metal layer 13.

The second external connection metal layer 13 is used for mounting electronic components. The running temperature of the bare chip 1 based on the third generation semiconductor material would reach 200°C or even higher, and the normal operation of other devices would be affected after the heat is transferred to the second external connection metal layer 13. Therefore, the arrangement of the thermal barrier 10 between the first chip board 3 and the second chip board 11 can help prevent the high-temperature heat generated by bare chip 1 from being transferred to the second chip board 11, so as to avoid affecting the normal operation of other electronic components.

In other embodiments, as shown in Figs. 3 and 4, the package substrate further includes a heat conducting layer 15, a first internal connection metal layer 8 and a heat conducting pillar 14. The heat conducting layer 15 is arranged on the side surface of the first chip board 3 facing away from the first external connection metal layer 5, and the first internal connection metal layer 8 is formed on the heat conducting layer 15.

The package substrate is provided with a plurality of heat conducting holes, which extend from the surface of the first internal connection metal layer 8 to expose the rigid substrate 2, and the heat conducting pillar 14 is arranged in the heat conducting holes. The bare chip 1 radiates heat to the bottom of the package substrate through the heat conducting layer 15 and the heat conducting pillar 14, so as to prevent the first internal connection metal layer 8 from affecting the heat dissipation of the bare chip 1.

The heat conducting pillar 14 is formed by electroplating copper in the heat conducting hole.

In other embodiments, the rigid substrate 2 made of high thermal conductivity material can be provided with an accommodating groove, and the bare chip 1 can be fixed in the accommodating groove of the rigid substrate 2. Simply covering the bare chip 1 with the insulation layer 4 allows the bare chip 1to be insulated and packaged in the first chip board 3.

## Claims

1. A packaging method for a power chip embedded package substrate, comprising the following steps:
acquiring a first chip board (3), and opening a through groove penetrating along a thickness direction on the first chip board (3);
fixing a bare chip (1) on a rigid substrate (2);
embedding the bare chip (1) and the rigid substrate (2) as a whole into the through groove of the first chip board (3);
pressing an insulation layer (4) on the first chip board (3), the insulation layer (4) covers the bare chip (1) in the through groove;
forming a first external connection metal layer (5) on the insulation layer (4); and
machining a plurality of blind holes (16) on a surface of the first external connection metal layer (5), the blind holes (16) realize 3D vertical interconnection between the bare chip (1) and the first external connection metal layer (5), and between the rigid substrate (2) and the first external connection metal layer (5), respectively;
before embedding the bare chip (1) and the rigid substrate (2) as a whole into the through groove of the first chip board (3), the method further comprises:
fixing a cushion block (9) on the rigid substrate (2), the cushion block (9) and the bare chip (1) are positioned at the same side of the rigid substrate (2); and
performing signal fan-out of the bare chip (1), by the cushion block (9) via the blind hole (16);
**characterized in that** the method further comprises:
forming a thermal barrier (10) on the first external connection metal layer (5);
acquiring a second chip board (11), forming a second internal connection metal layer (12) on a side surface of the second chip board (11), and forming a second external connection metal layer (13) on another side surface of the second chip board (11);
pressing the second internal connection metal layer (12) of the second chip board (11) on the thermal barrier (10) to obtain a multilayer board; and
performing drilling, copper deposition and electroplating process on the multilayer board.

2. The packaging method for a power chip embedded package substrate of claim 1, wherein pressing an insulation layer (4) on the first chip board (3), the insulation layer (4) covers the bare chip (1) in the through groove comprises:
forming the insulation layer (4) on a side surface of the first chip board (3) facing away from the rigid substrate (2), and the insulation layer (4) fills the through groove and wraps the bare chip (1).

3. The packaging method for a power chip embedded package substrate of claim 1, wherein a side surface of the rigid substrate (2) facing away from the bare chip (1) is flush with a surface of the first chip board (3).

4. The packaging method for a power chip embedded package substrate of claim 3, further comprising:
forming a heat conducting layer (15) on a side surface of the first chip board (3) facing away from the first external connection metal layer (5);
forming a first internal connection metal layer (8) on the heat conducting layer (15);
machining a heat conducting hole extending along the thickness direction of the first chip board (3) on a surface of the first internal connection metal layer (8), and exposing the rigid substrate (2) from the heat conducting hole; and
forming a heat conducting pillar (14) in the heat conducting hole.

5. The packaging method for a power chip embedded package substrate of claim 1, wherein machining a plurality of blind holes (16) on a surface of the first external connection metal layer (5), the blind holes (16) realize 3D vertical interconnection between the bare chip (1) and the first external connection metal layer (5), and between the rigid substrate (2) and the first external connection metal layer (5), comprises:
windowing the first external connection metal layer (5) to form a plurality of open pores, and exposing the insulation layer (4) from the open pores; and
machining a conductive hole extending along the thickness direction of the first chip board (3) at an exposure position of the insulation layer (4) to form the blind hole (16).

6. The packaging method for a power chip embedded package substrate of claim 5, wherein the conductive hole is processed by laser drilling and hole metallization.

7. The packaging method for a power chip embedded package substrate of claim 1, wherein fixing a bare chip (1) on a rigid substrate (2) comprises:
fixing the bare chip (1) on the rigid substrate (2) through nano-silver sintering, eutectic bonding or reflow soldering process.

## Patentansprüche

1. Ein Verfahren zum Verkapseln eines Verkapselungssubstrats mit eingebettetem Leistungschip, umfassend die folgenden Schritte:
Bereitstellen einer ersten Substratplatte mit eingebettetem Chip (3) und Ausbilden einer die erste Substratplatte mit eingebettetem Chip (3) in Dickenrichtung durchdringenden Durchgangsnut;
Befestigen eines nackten Chips (1) auf einem starren Substrat (2);
Einbetten des nackten Chips (1) und des starren Substrats (2) als Ganzes in die Durchgangsnut der ersten Substratplatte mit eingebettetem Chip (3);
Aufpressen einer Isolationsschicht (4) auf die erste Substratplatte mit eingebettetem Chip (3), wobei die Isolationsschicht (4) den nackten Chip (1) in der Durchgangsnut abdeckt;
Bilden einer ersten externen Metallverbindungsschicht (5) auf der Isolationsschicht (4); und
Bearbeiten einer Vielzahl von Blindbohrungen (16) auf einer Oberfläche der ersten externen Metallverbindungsschicht (5), wobei die Blindbohrungen (16) jeweils eine 3D-vertikale Verbindung zwischen dem nackten Chip (1) und der ersten externen Metallverbindungsschicht (5) sowie zwischen dem starren Substrat (2) und der ersten externen Metallverbindungsschicht (5) herstellen;
Vor dem Einbetten des nackten Chips (1) und des starren Substrats (2) als Ganzes in die Durchgangsnut der ersten Substratplatte mit eingebettetem Chip (3) umfasst das Verfahren ferner:
Befestigen eines Abstandselements (9) auf dem starren Substrat (2), wobei das Abstandselement (9) und der nackte Chip (1) auf derselben Seite des starren Substrats (2) angeordnet sind;
Durchführen eines Signal-Fan-outs des nackten Chips (1) über das Abstandselement (9) durch die Blindbohrung (16); **dadurch gekennzeichnet, dass** das Verfahren ferner umfasst:
Bilden einer thermischen Barriere (10) auf der ersten externen Metallverbindungsschicht (5);
Bereitstellen einer zweiten Substratplatte mit eingebettetem Chip (11), Bilden einer zweiten internen Metallverbindungsschicht (12) auf einer Seitenfläche der zweiten Substratplatte mit eingebettetem Chip (11) sowie Bilden einer zweiten externen Metallverbindungsschicht (13) auf einer anderen Seitenfläche der zweiten Substratplatte mit eingebettetem Chip (11);
Aufpressen der zweiten internen Metallverbindungsschicht (12) der zweiten Substratplatte mit eingebettetem Chip (11) auf die thermische Barriere (10), um eine Mehrlagenplatte zu erhalten;
Durchführen von Bohrungen, Kupferauftrag und Galvanisierungsprozessen auf der Mehrlagenplatte.

2. Das Verfahren zum Verkapseln eines Verkapselungssubstrats mit eingebettetem Leistungschip gemäß Anspruch 1, wobei das Aufpressen einer Isolationsschicht (4) auf die erste Substratplatte mit eingebettetem Chip (3), wobei die Isolationsschicht (4) den nackten Chip (1) in der Durchgangsnut abdeckt, umfasst:
Bilden der Isolationsschicht (4) auf der lateralen Seitenfläche der ersten Substratplatte mit eingebettetem Chip (3), die vom starren Substrat (2) abgewandt ist, wobei die Isolationsschicht (4) die Durchgangsnut füllt und den nackten Chip (1) umschließt.

3. Das Verfahren zum Verkapseln eines Verkapselungssubstrats mit eingebettetem Leistungschip gemäß Anspruch 1, wobei eine Seitenfläche des starren Substrats (2), die vom nackten Chip (1) abgewandt ist, mit einer Oberfläche der ersten Substratplatte mit eingebettetem Chip (3) bündig ist.

4. Das Verfahren zum Verkapseln eines Verkapselungssubstrats mit eingebettetem Leistungschip gemäß Anspruch 3, ferner umfassend:
Bilden einer wärmeleitenden Schicht (15) auf der lateralen Seitenfläche der ersten Substratplatte mit eingebettetem Chip (3), die von der ersten externen Metallverbindungsschicht (5) abgewandt ist;
Bilden einer ersten internen Metallverbindungsschicht (8) auf der wärmeleitenden Schicht (15);
Bearbeiten eines wärmeleitenden Lochs, das in Dickenrichtung der ersten Substratplatte mit eingebettetem Chip (3) verläuft, auf einer Oberfläche der ersten internen Metallverbindungsschicht (8), wobei das starre Substrat (2) aus dem wärmeleitenden Loch freigelegt wird; und
Bilden einer wärmeleitenden Säule (14) im wärmeleitenden Loch.

5. Das Verfahren zum Verkapseln eines Verkapselungssubstrats mit eingebettetem Leistungschip gemäß Anspruch 1, wobei das Bearbeiten einer Mehrzahl von Blindbohrungen (16) auf einer Oberfläche der ersten externen Metallverbindungsschicht (5), wobei die Blindbohrungen (16) die 3D-vertikale Verbindung zwischen dem nackten Chip (1) und der ersten externen Metallverbindungsschicht (5) sowie zwischen dem starren Substrat (2) und der ersten externen Metallverbindungsschicht (5) realisieren, umfasst:
Bildung von Durchbrüchen in der ersten externen Metallverbindungsschicht (5), um eine Mehrzahl offener Poren zu erzeugen und die Isolationsschicht (4) durch die offenen Poren freizulegen;
Bearbeiten eines leitfähigen Lochs in Richtung der Dicke der ersten Substratplatte mit eingebettetem Chip (3) an der freigelegten Stelle der Isolationsschicht (4), um die Blindbohrung (16) zu bilden.

6. Das Verfahren zum Verkapseln eines Verkapselungssubstrats mit eingebettetem Leistungschip gemäß Anspruch 5, wobei das leitfähige Loch durch Laserdurchbohren und Metallisieren des Lochs bearbeitet wird.

7. Das Verfahren zum Verkapseln eines Verkapselungssubstrats mit eingebettetem Leistungschip gemäß Anspruch 1, wobei das Fixieren des nackten Chips (1) auf dem starren Substrat (2) Folgendes umfasst:
Fixieren des nackten Chips (1) auf dem starren Substrat (2) durch Nano-Silber-Sintern, eutektisches Verbinden oder Reflow-Lötverfahren.

## Revendications

1. Procédé de conditionnement pour un substrat de boîtier intégré à une puce de puissance, comprenant les étapes suivantes :
acquisition d'une première plaque de substrat avec puce intégrée (3) et ouverture d'une rainure traversante selon la direction d'épaisseur sur la première plaque de substrat avec puce intégrée (3) ;
fixation d'une puce nue (1) sur un substrat rigide (2) ;
insertion de la puce nue (1) et du substrat rigide (2) en tant qu'ensemble dans la rainure traversante de la première plaque de substrat avec puce intégrée (3) ;
pressage d'une couche d'isolation (4) sur la première plaque de substrat avec puce intégrée (3), la couche d'isolation (4) recouvrant la puce nue (1) dans la rainure traversante ;
formation d'une première couche de métal de connexion externe (5) sur la couche d'isolation (4) ;
usinage d'une pluralité de trous borgnes (16) sur une surface de la première couche de métal de connexion externe (5), ces trous borgnes (16) réalisant respectivement l'interconnexion verticale 3D entre la puce nue (1) et la première couche de métal de connexion externe (5), ainsi qu'entre le substrat rigide (2) et la première couche de métal de connexion externe (5).
Avant d'insérer la puce nue (1) et le substrat rigide (2) en tant qu'ensemble dans la rainure traversante de la première plaque de substrat avec puce intégrée (3), le procédé comprend en outre :
fixation d'un élément d'espacement (9) sur le substrat rigide (2), l'élément d'espacement (9) et la puce nue (1) étant positionnés du même côté du substrat rigide (2) ; et
réalisation du fan-out de signaux de la puce nue (1) par l'élément d'espacement (9) via le trou borgne (16) ;
**caractérisé en ce qu'**il comprend en outre :
formation d'une barrière thermique (10) sur la première couche de métal de connexion externe (5) ;
acquisition d'une deuxième plaque de substrat avec puce intégrée (11), formation d'une deuxième couche de métal de connexion interne (12) sur une surface de la deuxième plaque de substrat avec puce intégrée (11), et formation d'une deuxième couche de métal de connexion externe (13) sur l'autre surface de la deuxième plaque de substrat avec puce intégrée (11) ;
pressage de la deuxième couche de métal de connexion interne (12) de la deuxième plaque de substrat avec puce intégrée (11) sur la barrière thermique (10) pour obtenir une carte multicouche ; et
réalisation d'un perçage, d'un dépôt de cuivre et d'un placage électrolytique sur la carte multicouche.

2. Le procédé de conditionnement pour un substrat de boîtier intégré à une puce de puissance selon la revendication 1, dans lequel le pressage d'une couche d'isolation (4) sur la première plaque de substrat avec puce intégrée (3), la couche d'isolation (4) recouvrant la puce nue (1) dans la rainure traversante, comprend :
formation de la couche d'isolation (4) sur une surface latérale de la première plaque de substrat avec puce intégrée (3) orientée à l'opposé du substrat rigide (2), la couche d'isolation (4) remplissant la rainure traversante et enveloppant la puce nue (1).

3. Le procédé de conditionnement pour un substrat de boîtier intégré à une puce de puissance selon la revendication 1, dans lequel une surface latérale du substrat rigide (2) orientée à l'opposé de la puce nue (1) est au même niveau qu'une surface de la première plaque de substrat avec puce intégrée (3).

4. Le procédé de conditionnement pour un substrat de boîtier intégré à une puce de puissance selon la revendication 3, comprenant en outre :
formation d'une couche conductrice de chaleur (15) sur une surface latérale de la première plaque de substrat avec puce intégrée (3) orientée à l'opposé de la première couche de métal de connexion externe (5) ;
formation d'une première couche de métal de connexion interne (8) sur la couche conductrice de chaleur (15) ;
usinage d'un trou conducteur de chaleur s'étendant selon la direction d'épaisseur de la première plaque de substrat avec puce intégrée (3) sur une surface de la première couche de métal de connexion interne (8), de manière à exposer le substrat rigide (2) depuis le trou conducteur de chaleur ; et
formation d'un pilier conducteur de chaleur (14) dans le trou conducteur de chaleur.

5. Le procédé de conditionnement pour un substrat de boîtier intégré à une puce de puissance selon la revendication 1, dans lequel l'usinage d'une pluralité de trous borgnes (16) sur une surface de la première couche de métal de connexion externe (5), les trous borgnes (16) réalisant une interconnexion 3D verticale entre la puce nue (1) et la première couche de métal de connexion externe (5), et entre le substrat rigide (2) et la première couche de métal de connexion externe (5), comprend :
formation d'ouvertures dans la première couche de métal de connexion externe (5) pour former une pluralité de pores ouverts, de manière à exposer la couche d'isolation (4) depuis les pores ouverts ; et
l'usinage d'un trou conducteur s'étendant selon la direction d'épaisseur de la première plaque de substrat avec puce intégrée (3) à un emplacement exposé de la couche d'isolation (4) pour former le trou borgne (16).

6. Le procédé de conditionnement pour un substrat de boîtier intégré à une puce de puissance selon la revendication 5, dans lequel le trou conducteur est traité par perçage laser et métallisation du trou.

7. Le procédé de conditionnement pour un substrat de boîtier intégré à une puce de puissance selon la revendication 1, dans lequel la fixation de la puce nue (1) sur le substrat rigide (2) comprend :
la fixation de la puce nue (1) sur le substrat rigide (2) par frittage d'argent nanoparticulaire, brasage eutectique ou refusion de soudure.
